# EUROPÄISCHE PATENTANMELDUNG

(11) **EP 0 603 614 A1**
(43) Veröffentlichungstag der Anmeldung: **29.06.1994**
(21) Anmeldenummer: 93119543.2
(22) Anmeldetag: 03.12.1993
(51) Int. Cl.: G06F 11/26, G01R 31/318

(54) **Verfahren zum Testen eines Gate-Arrays auf einer bestückten Leiterplatte**

(30) Priorität: 22.12.1992 EP 92121801
(71) Anmelder: SIEMENS AKTIENGESELLSCHAFT, D-80333 München (DE)
(72) Erfinder: Detlef, Betsch, Dipl.-Ing., D-81476 München (DE)

(57) **Zusammenfassung**

Das Testen eines Gate-Arrays soll auf eine möglichst einfache Weise erfolgen. Um dies zu erreichen, wird ein Gate-Array zum Test auf einer Leiterplatte nicht mit derjenigen Schaltungslogik geladen, die in einem auf der Leiterplatte befindlichen Betriebs-PROM gespeichert ist, sondern mit einer einfachen Testlogik von einem externen Test-PROM oder einem Testautomaten.

## Beschreibung

Für die elektrische Prüfung reprogrammierbarer Gate-Arrays auf einer bestückten Leiterplatte zur Erkennung von Fertigungsfehlern werden bisher der in das Gate-Array geladenen Schaltungslogik angepaßte Testprogramme erstellt. Dieses ist bei komplexer Schaltungslogik sehr aufwendig oder sogar unmöglich.

Der Erfindung liegt die Aufgabe zugrunde, ein einfaches Verfahren zum Testen eines Gate-Arrays auf einer bestückten Leiterplatte anzugeben.

Diese Aufgabe wird durch die Merkmale des Anspruchs 1 gelöst.

Aufgrund des erfindungsgemäßen Verfahrens wird erreicht, daß für gleiche Bausteine, d.h. für einen bestimmten Bausteintyp, nur noch ein einziger und zudem einfacher Test benötigt wird.

Im folgenden wird die Erfindung anhand der Zeichnung näher erläutert.

Die Figur zeigt einen schematischen Schaltplan eines speziellen Gate-Arrays mit Zusatzbeschaltung zur Durchführung des erfindungsgemäßen Verfahrens.

Die prinzipielle Idee der Erfindung besteht darin, ein Gate-Array zum Test auf der Leiterplatte nicht mit derjenigen Schaltungslogik zu laden, die in einem auf der Leiterplatte befindlichen Betriebs-PROM's PB gespeichert ist, sondern mit einer einfachen Testlogik von einem externen Test-PROM PT oder einem Testautomaten. Dadurch wird erreicht, daß für gleiche Gate-Arrays, d.h. für einen bestimmten Typ von Gate-Arrays nur noch ein einziger und zudem einfacher Test zur Erkennung von Fertigungsfehlern auf der Leiterplatte benötigt wird.

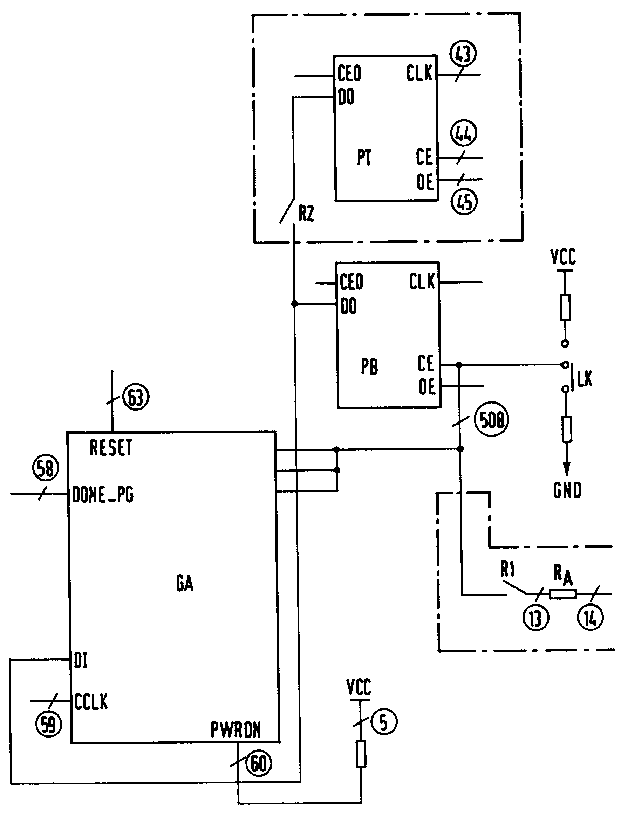

FIG 1 zeigt ein auf einer Leiterplatte befindliches Gate-Array GA mit zugehörigem Betriebs-PROM PB, sowie eine Zusatzbeschaltung zur Durchführung des erfindungsgemäßen Verfahrens. Bei dem schematisch dargestellten Gate-Array handelt es sich um den Baustein XC3030-84 PLCC der Firma XILINX. Die Zusatzbeschaltung ist in FIG 1 durch gestrichelte Umrahmung markiert und umfaßt ein Test-PROM PT, ein erstes Relais R1, ein zweites Relais R2 und einen Adapterwiderstand R_{A}. Die eingekreist dargestellten Zahlen repräsentieren die Nummern von Testnadeln, über die geeignete Stimulationssignale an das zu testende Gate-Array angelegt werden.

Das erfindungsgemäße Verfahren gliedert sich im wesentlichen in zwei Verfahrensschritte, nämlich einen ersten Verfahrenssschritt, bei dem eine bausteinspezifische Testlogik in das Gate-Array geladen wird und in einen darauffolgenden zweiten Verfahrensschritt, bei dem ein der geladenen Testlogik angepaßter Test durchgeführt wird.

Im folgenden wird der Ablauf des erfindungsgemäßen Verfahrens näher erläutert. Zunächst wird ein Brückenstecker LK geöffnet. Daraufhin wird das Gate-Array GA durch Schließen des ersten Relais R1 und Anlegen von +5V an die Testnadel 14 auf den Slave-Mode eingestellt und das Betriebs-PROM PB deaktiviert. Sodann wird der Datenausgang DO des Test-PROM's über das zweite Relais R2 mit dem seriellen Dateneingang DI des Gate-Arrays verbunden. Als nächstes wird das Gate-Array durch Anlegen von +5V an die Testnadeln 58, 60 und 63 initialisiert. Sodann wird das Test-PROM durch Anlegen entsprechender Signale an die Testnadeln 44 und 45 rückgesetzt und aktiviert. Schließlich wird das Gate-Array durch gleichzeitiges Takten seines Takteinganges CCLK über die Testnadel 59 und des Takteingangs CLK des Test-PROM's über die Nadel 43 mit den Daten aus dem Test-PROM konfiguriert. Die Taktanzahl entspricht der Anzahl der Daten, die zur Konfiguration bzw. zum Laden der Testlogik benötigt werden. Damit ist der erste Verfahrensschritt des erfindungsgemäßen Verfahrens abgeschlossen. Das genannte Deaktivieren des Betriebs-PROM's PB kann auch vom Testautomaten direkt übernommen werden. Bei genügend großer Speichertiefe der Treiber des Testautomaten kann das Gate-Array sogar mit Daten aus dem Testautomaten seriell oder parallel konfiguriert werden. In diesem Fall wird für das Laden des Gate-Arrays keine Zusatzbeschaltung mehr benötigt.

Nun folgt in einem zweiten Verfahrensschritt der eingentliche Test, indem an diejenigen Pins des Gate-Arrays, die den Eingängen der Testlogikschaltung entsprechen, über nicht dargestellte weitere Testnadeln entsprechende Testsignale angelegt werden und an denjenigen Pins des Gate-Arrays, die den Ausgängen der Testlogikschaltung entsprechen, über ebenfalls nicht dargestellte Meßnadeln die Meßsignale aufgenommen werden. Durch Vergleichen der empfangenen Meßsignale mit den erwarteten Meßsignalen können schließlich Fertigungsfehler erkannt werden.

Die Testlogikschaltung ist derart geartet, daß sich für jeden Eingangspin das Anlegen eines Testsignals (Pulssignal bestimmter Frequenz) mindestens an einem Ausgangspin bemerkbar macht, und daß jeder Ausgangspin über die Eingangspins mit dem Testsignal erreicht werden kann. Eine derartige Testlogikschaltung erhält man z.B., indem mehrere Eingänge über ein UND-Gatter auf einen Ausgang gelegt werden.

Der gesamte Ablauf des erfindungsgemäßen Verfahrens wird durch einen Testautomaten gesteuert, der die zur Durchführung des Tests notwendigen Testsignale erzeugt und die zur Auswertung des Tests empfangenen Meßsignale verarbeitet.

## Patentansprüche

1. Verfahren zum Testen eines Gate-Arrays auf einer bestückten Leiterplatte,
**dadurch gekennzeichnet**,
daß
a) anstelle einer Betriebslogik aus einem Betriebs-PROM (PB) eine Testlogik aus einem externen Test-PROM (PT) oder von einem Testautomaten in das Gate-Array (GA) geladen wird,
b) ein der Testlogik angepaßter Test durchgeführt wird.
